# EUROPEAN PATENT APPLICATION

(11) **EP 2 573 830 A2**
(43) Date of publication of application: **27.03.2013**
(21) Application number: 12181580.7
(22) Date of filing: 23.08.2012
(51) Int. Cl.: H01L 33/58, H01L 25/075

(54) **LIGHT-EMITTING CIRCUIT AND LUMINAIRE**

(30) Priority: 26.09.2011 JP 2011209309
(71) Applicant: Toshiba Lighting & Technology Corporation, Yokosuka-shi Kanagawa 237-8510 (JP)
(72) Inventor: Watanabe, Miho, Kanagawa, 237-8510 (JP); Betsuda, Nobuhiko, Kanagawa, 237-8510 (JP)
(74) Representative: Willquist, Sofia Ellinor

(57) **Abstract**

According to one embodiment, a light-emitting circuit (10) includes a substrate (11), a conductive section (16) formed on the substrate (11), a plurality of light-emitting elements (21) electrically connected to the conductive section (16) and mounted on the substrate (11), a sealing member (27) including phosphors provided to cover the light-emitting elements (21), and a diffusion layer (6) provided to cover the sealing member (27) such that light emitted from the sealing member (27) is made incident on the diffusion layer (6), the diffusion layer (6) including a plurality of columnar sections (61) perpendicular to the front surface side of the sealing member (27).

## Description

### FIELD

Embodiments described herein relate generally to a light-emitting circuit including light-emitting elements such as LED chips and a luminaire including the light-emitting circuit as a light source.

### BACKGROUND

In recent years, a light-emitting circuit including light-emitting elements, in particular, light-emitting diodes (hereinafter referred to as "LED chips") is expanded to various uses including a light source body such as an LED lamp of a bulb type that can replace an incandescent lamp and light sources of various luminaires such as a downlight and a spotlight. There is also known a light-emitting circuit that lights, for example, LED chips called high-power to obtain higher power.

When plural so-called high-power LED chips that can obtain a large optical output are mounted and formed as a module, from a viewpoint of a large chip area and thermal radiation properties, it is suitable to design a mounting interval wider than a mounting interval for LED chips having a small optical output (chips having a small area).

However, when the mounting interval is large, for example, in light radiated from a sealing member including phosphors for converting light from blue LED chips, the intensity of blue light with respect to the phosphors around the LED chips and the intensity of blue light with respect to the phosphors among the chips are different. Therefore, color unevenness on a radiation surface of the sealing member tends to occur.

Therefore, there is known light-emitting circuit including a diffusing section on the radiation surface of the sealing member as a method of solving the color unevenness.

### DESCRIPTION OF THE DRAWINGS

FIG. 1 is a perspective view of a luminaire according to an embodiment;
FIG. 2 is a front view of a light-emitting circuit according to the embodiment; and
FIG. 3 is a sectional view of the light-emitting circuit according to the embodiment.

### DETAILED DESCRIPTION

According to one embodiment, a light-emitting circuit includes a substrate, a substrate, a conductive section, a plurality of light-emitting elements, a sealing member and a diffusion layer. The conductive section is configured to be formed on the substrate. The plurality of light-emitting elements is configured to be electrically connected to the conductive section and mounted on the substrate. The sealing member is configured to be provided to cover the light-emitting elements. The sealing member includes phosphors. The diffusion layer is configured to be provided to cover the sealing member such that light emitted from the sealing member is made incident on the diffusion layer. The diffusion layer is configured to include a plurality of columnar sections perpendicular to a front surface side of the sealing member.

In the light-emitting circuit according to an embodiment, any of a metal base substrate, a ceramic base substrate, a resin material substrate formed of glass epoxy, and the like can be implemented as a substrate. Further, a DCB (Direct Copper Bonding) substrate, a DBA (Direct Brazing Aluminum) substrate, an AMC (Active Metal Brazed Copper) substrate, and the like can also be used. In the embodiment, a material such as Al2O3, ALN, or SiN can be used for a ceramic substrate.

In the embodiment, for example, an LED chip or an organic EL can be used for a semiconductor light-emitting element.

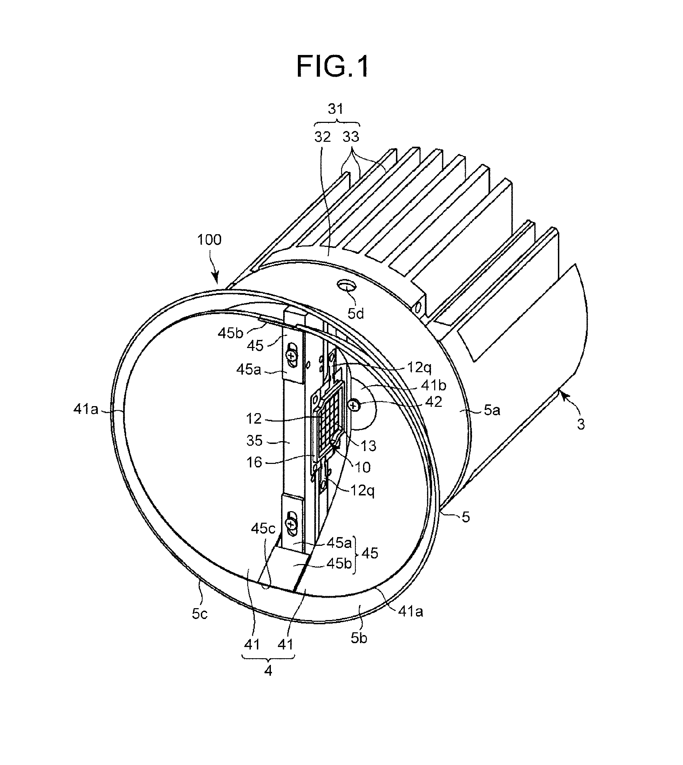

An embodiment is explained in detail below with reference to the accompanying drawings. A luminaire 100 according to this embodiment shown in FIG. 1 is a spotlight including two light-emitting circuits 10. The luminaire 100 includes the two light-emitting circuits 10, a member to be attached 3, a concave reflecting mirror 4, and a mirror supporting member 5. The light-emitting circuit 10 is a COB (chip on board) type.

The concave reflecting mirror 4 is formed of a pair of concave mirror members 41 made of aluminum. Reflection surfaces of the concave mirror members 41 are formed as parabolic surfaces and finished as mirror surfaces. The concave mirror member 41 includes a semiarcuate edge 41a located on a light emission side and a seat section 41b located on a base 32 side of a heat sink 31. The seat section 41b is formed flat along the base 32. The concave mirror member 41 is attached by a screw 42 with the seat section 41b set in contact with the front of the base 32 of the heat sink 31.

The pair of concave mirror members 41 fixed to the front side of the heat sink 31 face the light-emitting circuits 10 on both sides of a heat receiving section 35. The pair of concave mirror members 41 are arranged surface-symmetrically with respect to the heat receiving section 35. A light-emitting section of the light-emitting circuit 10 is opposed to the reflection surface formed by the parabolic surface of the concave mirror member 41. The center P of the light-emitting section of the light-emitting circuit 10 is arranged to be located at the focal point of the concave mirror member 41.

At an end of the heat receiving section 35 apart in the radial direction from the center of a light beam radiated from the luminaire 100, mirror holders 45 are fixed from the front side by screws. The mirror holder 45 integrally includes an attachment piece section 45a set in contact with the heat receiving section 35 and a closing piece section 45b bent along the reflection surface. The reflection surfaces of the pair of concave mirror members 41 are apart from each other because the heat receiving section 35 is inserted between the mirror members 41. When the attachment piece section 45a is screwed to the heat receiving section 35, the closing piece section 45b is arranged to close a gap between the concave mirror members 41. Consequently, the edge 41a of the concave mirror member 41 and a distal end edge 45c of the closing piece section 45b form a shape approximate to a circle.

The mirror supporting member 5 also serving as a cover of the concave reflecting mirror 4 includes a cylindrical base section 5a and a supporting section 5b extending in a trumpet shape from one end of the base section 5a. The supporting section 5b is formed in a taper shape having a diameter larger than the diameter of the base section 5a. When viewed from the front side, the supporting section 5b is formed in a circular shape. The base section 5a is struck against the front surface of the base 32 and the supporting section 5b is set in contact with the rear surface of the outer circumference of the concave reflecting mirror 4, whereby the mirror supporting member 5 is held between the base 32 and the circumference of the concave reflecting mirror 4. The mirror supporting member 5 supports the concave reflecting mirror 4 from the rear side.

After being arranged on the front side of the base 32 in advance, the mirror supporting member 5 is held by the concave mirror members 41 fixed to the base 32. An opening edge 5c formed in the supporting section 5b of the mirror supporting member 5 is located further on the front side, i.e., the light emission side than the edges 41a of the concave mirror members 41 and the distal end edges 45c of the mirror holders 45. The concave reflecting mirror 4 and the mirror holders 45 are housed in the mirror supporting member 5. A cable hole 5d is provided to insert an insulated coated electric wire connected to a power feed terminal.

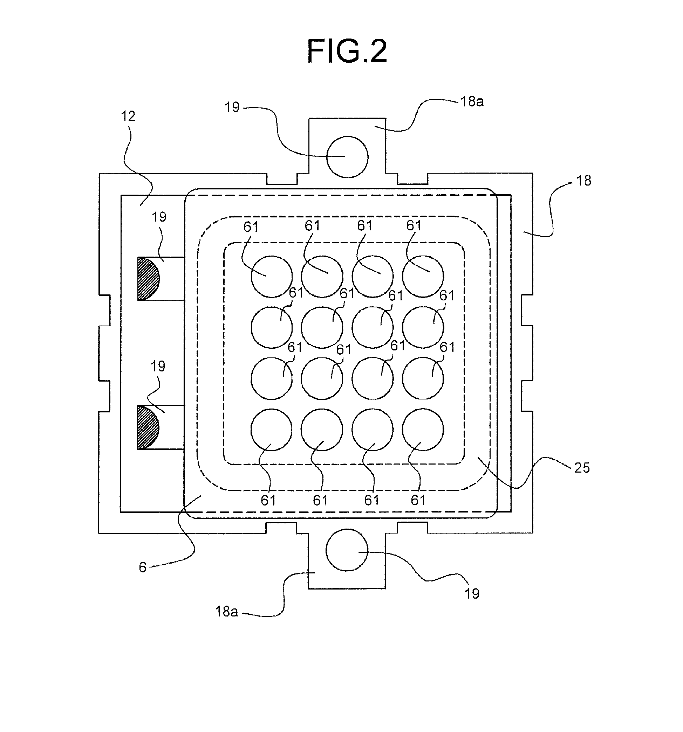

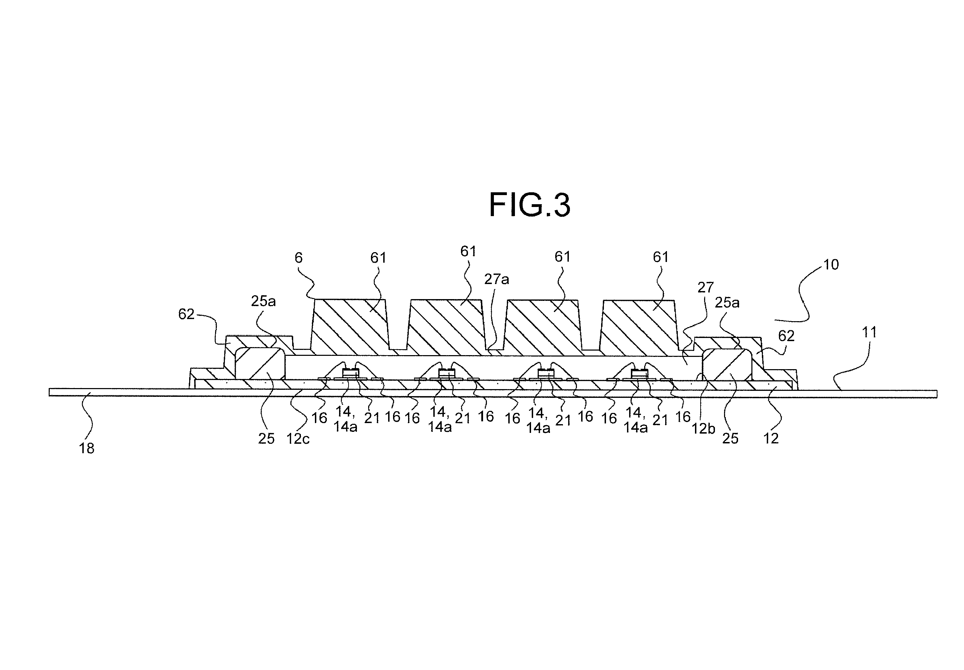

The light-emitting circuit 10 is explained with reference to FIGS. 2 and 3.

The light-emitting circuit 10 is a COB (chip onboard) type. As shown in FIGS. 2 and 3, the light-emitting circuit 10 includes a substrate 11, plural semiconductor light-emitting elements, for example, LED chips 21, a frame section 25, a translucent sealing member 27, and a diffusion layer 6.

The substrate 11 is formed of, for example, a DCB substrate. Specifically, as shown in FIG. 3 and the like, the substrate 11 includes a base material 12, front metal members 14, power feeding sections 16, and a rear metal member 18.

The base material 12 is formed of a flat plate made of a ceramic material such as Al2O3, ALN, or SiN.

As shown in FIG. 3, one surface forming the front surface of the base material 12 is a mounting surface 12b on which the LED chips 21 are mounted. A rear surface 12c of the base material 12 is formed of the other surface on the opposite side of the mounting surface 12b. The mounting surface 12b and the rear surface 12c are parallel to each other.

The front metal members 14 and the power feeding sections 16 are arranged on the front side of the base material 12. Specifically, the front metal members 14 and the power feeding sections 16 are directly joined to the mounting surface 12b of the base material 12 by a DCB method. The front metal members 14 are provided to radiate the heat of the LED chips 21 and reflect light of the LED chips 21.

The rear metal member 18 is arranged on the rear surface 12c side of the base material 12. Specifically, the rear metal member 18 is directly joined to the rear surface 12c of the base material 12 by the DCB method. All of the front metal members 14, the power feeding sections 16, and the rear metal member 18 are copper plates.

In the direct joining by the DCB method, a cooper oxide film is formed over the entire surface of the copper plate. The copper plate is arranged on the base material 12 with the copper oxide film faced to the base material 12 made of ceramics. The copper plate is heated at temperature lower than a melting temperature of the copper plate and higher than a melting temperature of the copper oxide film in a heating furnace, whereby a eutectic molten material is formed on a joining interface between the copper plate and the base material 12 made of ceramics. The copper plate is joined to the mounting surface 12b or the rear surface 12c of the base material 12 by the eutectic molten material.

The front metal members 14 directly joined to the mounting surface 12b include plural pattern sections 14a divided in a matrix shape. The pattern sections 14a are arranged at intervals lengthwise and crosswise to correspond to mounting positions of the plural LED chips 21 and disposed in the matrix shape as explained above.

The power feeding sections 16 directly joined to the mounting surface 12b are arranged adjacent to both sides of the pattern sections 14a in an array direction of the pattern sections 14a (e.g., the left right direction in FIG. 3) with the pattern sections 14a placed among the power feeding sections 16. One ends of a pair of the power feeding sections 16 are directly joined to the mounting surface 12b and respectively provided adjacent to the pattern sections 14a arranged at ends in the array direction of the pattern sections 14a.

On the surfaces of the front meal members 14 and the power feeding sections 16, a not-shown metal layer far thinner than the front metal members 14 and the power feeding sections 16 is laminated. The metal layer includes a base plated layer formed of a nickel plated layer or the like plated at thickness of, for example, about 3 µm on the front surface and a front layer plated layer plated at thickness of, for example, about 0.3 µm on the base plated layer. The front layer plated layer is formed of a plated layer of, for example, copper, silver, gold, or the like. It is desirable to form the surface layer plated layer with the silver plated layer because high light reflection performance can be secured by the pattern sections 14a that form the front metal members 14.

The rear metal member 18 directly joined to the rear surface 12c of the base material 12 by the DCB method is provided to, for example, prevent a warp of the substrate 11 and radiate the heat of the substrate 11. The rear metal member 18 desirably covers the entire region of the rear surface 12c of the base material 12 as shown in FIG. 3. The rear metal member 18 is a flat plate. As shown in FIGS. 1 to 3, the rear metal member 18 integrally includes fixing sections 18a in plural places, for example, two places.

The fixing sections 18a are projected from the periphery of the base material 12. Screw inserting sections, for example, screw inserting holes 19 are formed in the fixing sections 18a. The screw inserting sections can also be formed as recesses having a cutout shape.

The thicknesses of the front metal members 14, the power feeding sections 16, and the rear meal members 18 formed of tabular metal materials and joined to the base material 12 can be set to desired thicknesses because the front metal members 14, the power feeding sections 16, and the rear meal members 18 are provided to be directly joined to the base material 12. The thicknesses are selected in a range of, for example, 200 µm to 500 µm.

For example, LED chips that emit blue light are used as the LED chips 21. The LED chip 21 is a semiconductor bare chip in which a semiconductor light-emitting layer that emits single-color blue light is laminated on an element substrate made of sapphire or the like and a pair of positive and negative element electrodes are arranged on the semiconductor light-emitting layer.

The LED chips 21 are mounted on the mounting surface 12b of the base material 12 by respectively fixing the rear surfaces of the element substrates 21a located on the opposite side of the semiconductor light-emitting layers 21b to the pattern sections 14a with a die bond material 22. The die bond material 22 is formed of a silver paste or a resin adhesive, for example, transparent silicone resin.

The mounting of the LED chips 21 is performed by applying temperature of about 300°C. In this case, the thickness of the rear metal member 18 is smaller than the thickness of the front metal members 14 and the power feeding sections 16. Therefore, on the basis of a difference between an area occupied by the front metal members 14 and the power feeding sections 16 in the mounting surface 12b of the base material 12 and an area occupied by the rear metal member 18 in the rear surface 12c of the base material 12, in other words, a volume difference of the metal materials on the base material front and rear surfaces, which can be converted from the areas and the thicknesses, it is possible to suppress the base material 12 from warping to be convex on the mounting surface 12b side of the base material 12 and concave on the rear surface 12c side of the base material 12.

The frame section 25 is provided on the base material 12 to cover the periphery of the plural LED chips 21, the front metal members 14, on which the LED chips 21 are mounted, and the power feeding sections 16. The frame section 25 is formed to increase light-reflectance. In this embodiment, the frame section 25 is formed including white silicone resin and a filler. Visible light reflectance of the frame section 25 is equal to or higher than 80%.

The sealing member 27 are filled and provided on the inner side of the frame section 25 to cover the plural LED chips 21. The sealing member 27 is made of translucent synthetic resin, for example, transparent silicone resin having gas permeability. Not-shown phosphors are mixed in the sealing member 27 by an appropriate amount. The phosphors are excited by light emitted by the LED chips 21 and radiate light of a color different from a color of the light emitted by the LED chips 21. In this embodiment in which the LED chips 21 emit the blue light, to enable the light-emitting circuit 10 to emit white light, as the phosphors, yellow phosphors that radiate yellowish light having a complementary relation with the blue light are used. The sealing member 27 mixed with the phosphors in this way forms a light-emitting section of the light-emitting circuit 10 because the phosphors emit light.

A front surface side 27a of the sealing member 27 is formed in a position lower than a top 25a of the frame section 25.

The diffusion layer 6 is provided to cover the front surface side 27a of the sealing member 27. A peripheral diffusion section 62 is provided to cover the entire outer surface, which is a portion exposed to the outer side of the frame section 25, and a part of the base material 12 on the outer side of the frame section 25.

The diffusion layer 6 is made of silicone resin, which is transparent resin. The diffusion layer 6 is formed by adding a filler made of ceramics on the inside. As the filler, silica, calcium carbonate, hollow silica, or the like can be used. In this embodiment, dimethyl silicone added with 15 wt% of hollow Si02 with an average particle diameter of 3 µm having an air layer in the particle center is used.

Further, in the diffusion layer 6, plural columnar sections 61 are integrally formed. The columnar sections 61 are provided such that the center portions thereof are respectively located right above the LED chips 21. Sixteen columnar sections 61 are formed by transfer mold. A taper of about 5 degrees is provided on the side surfaces of the columnar sections 61.

The operation of the luminaire 100 according to this embodiment is explained. When the luminaire 100 is turned on, the LED chips 21 of the light-emitting circuit 10 emit light. The sealing member 27 including the phosphors is excited by the light of the LED chips 21 to emit white light. The light radiated by the sealing member 27 is reflected by the concave mirror members 41 opposed to the sealing member 27 and emitted in a light radiation direction of the luminaire 100. Projection patterns of the light reflected by the pair of concave mirror members 41 are substantially circular. The patterns can substantially merge on an irradiation target sufficiently far from the luminaire 100 and realize irradiation light like spotlight.

The light-emitting circuit 10 according to this embodiment includes the diffusion layer 6 to cover the front surface side 27a of the sealing member 27. The columnar sections 61 are formed in the diffusion layer 6. Therefore, in addition to the diffusing action by the filler of the diffusion layer 6, visible light from the phosphors and blue light not converted by the phosphors are mixed in the columnar sections 61. The luminous intensity distribution of emitted light emitted from the columnar sections 61 can be suppressed from excessively spreading by the condensing action by the columnar shape. Further, the blue light not converted by the phosphors scatters in the columnar sections 61 and returns into the sealing member 27. An amount of phosphors for setting a target correlation color temperature can be suppressed. Therefore, since the diffusion layer 6 including the columnar sections 61 is provided separately from the sealing member 27, it is possible to easily suppress color unevenness and suppress deterioration in a light beam.

In this embodiment, the columnar sections 61 are provided such that the center portions thereof are respectively located right above the LED chips 21. Therefore, since no fluctuation occurs in emitted light from the columnar sections 61, it is possible to obtain, at a high level, a comprehensive effect of suppressing light unevenness.

In this embodiment, the sealing member 27 and the diffusion layer 6 are separately formed. Therefore, since the filler and the silicone included in the diffusion layer 6 have a small refractive index difference from the air compared with the sealing member 27, it is possible to improve a light beam compared with a light beam obtained when only the sealing member 27 is provided. The refractive index difference is small in the configuration in this embodiment compared with a refractive index difference that occurs if a sealing member including phosphors and a diffusion layer are integrally formed. Therefore, it is possible to easily improve a light beam. Further, the blue light not converted by the phosphors in the sealing member 27 is made incident in the sealing member 27 again after scattering in the diffusion layer 6. Therefore, an amount of phosphors in realizing a desired color temperature may be small compared with an amount of phosphors required if the sealing member and the diffusion layer are integrally formed. In any case, the sealing member 27 and the diffusion layer 6 separately configured in design and manufacturing are more effective.

In this embodiment, the diffusion layer 6 is provided to cover the front surface side 27a of the sealing member 27. The peripheral diffusion section 62 is provided to cover the entire outer surface, which is a portion exposed to the outer side, of the frame section 25 and a part of the base material 12 on the outer side of the frame section 25. With this configuration, even the luminous intensity distribution of light emitted from the frame section 25 side of the front surface side 27a of the sealing member 27 or light on an optical path directly emitted to the outside without being reflected on the frame section 25 can be suppressed from spreading by the peripheral diffusion section 62. Even if the light is blue light not converted by the phosphors, the light is scattered to return into the sealing member 27 by the peripheral diffusion section 62. Therefore, it is possible to further suppress color unevenness.

In this embodiment, the front surface side 27a of the sealing member 27 is formed in the position lower than the top 25a of the frame section 25. Therefore, light on an optical path in the side direction or the oblique upward direction in the sealing member 27 is reflected to the inner side direction by the frame section 25. Therefore, it is possible to suppress the luminous intensity distribution of the light from excessively spreading. Further, since the light is easily made incident on the diffusion layer 6 in which the columnar sections 61 are formed, it is easy to suppress color unevenness, deterioration in a light beam, and a luminous intensity distribution angle.

While certain embodiments have been described, these embodiments have been presented by way of example only, and are not intended to limit the scope of the inventions. Indeed, the novel embodiments described herein may be embodied in a variety of other forms; furthermore, various omissions, substitutions, and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting circuit (10) comprising:
a substrate (11);
a conductive section (16) configured to be formed on the substrate (11);
a plurality of light-emitting elements (21) configured to be electrically connected to the conductive section (16) and mounted on the substrate (11);
a sealing member (27) configured to be provided to cover the light-emitting elements (21), the sealing member (27) including phosphors; and
a diffusion layer (6) configured to be provided to cover the sealing member (27) such that light emitted from the sealing member (27) is made incident on the diffusion layer (6), the diffusion layer (6) including a plurality of columnar sections (61) perpendicular to a front surface side of the sealing member (27).

2. The light-emitting circuit (10) according to claim 1, further comprising a frame section configured to be provided around the plurality of the light-emitting elements (21) to surround the plurality of the light-emitting elements (21), wherein
the sealing member (27) is provided on an inner side of the frame section, and
the diffusion layer (6) is formed to cover an entire outer surface of the frame section.

3. The light-emitting circuit (10) according to claim 1 or 2, wherein the sealing member (27) is formed in a position lower than a top of the frame section.

4. The light-emitting circuit (10) according to any one of claims 1 to 3, wherein the sealing member (27) and the diffusion layer (6) are separately formed.

5. The light-emitting circuit (10) according to any one of claims 1 to 4, wherein a refractive index difference from air in the diffusion layer (6) is small compared with a refractive index difference in the sealing member (27).

6. The light-emitting circuit (10) according to any one of claims 1 to 5, wherein a center of the columnar section (61) is located on the light-emitting element (21).

7. The light-emitting circuit (10) according to any one of claims 1 to 6, wherein centers of the plurality of columnar sections (61) are respectively located on the plurality of light-emitting elements (21).

8. A luminaire (100) comprising:
a conductive section (16) configured to be formed on a substrate (11);
a plurality of light-emitting elements (21) configured to be electrically connected to the conductive section (16) and mounted on the substrate (11);
a sealing member (27) configured to be provided to cover the light-emitting elements (21), the sealing member (27) including phosphors; and
a diffusion layer (6) configured to be provided to cover the sealing member (27) such that light emitted from the sealing member (27) is made incident on the diffusion layer (6), the diffusion layer (6) including a plurality of columnar sections (61) perpendicular to a front surface side of the sealing member (27).

9. The luminaire (100) according to claim 8, further comprising a frame section configured to be provided around the plurality of the light-emitting elements (21) to surround the plurality of the light-emitting elements (21), wherein
the sealing member (27) is provided on an inner side of the frame section, and
the diffusion layer (6) is formed to cover an entire outer surface of the frame section.

10. The luminaire (100) according to claim 8 or 9, wherein the sealing member (27) is formed in a position lower than a top of the frame section.

11. The luminaire (100) according to any one of claims 8 to 10, wherein the sealing member (27) and the diffusion layer (6) are separately formed.

12. The luminaire (100) according to any one of claims 8 to 11, wherein a refractive index difference from air in the diffusion layer (6) is small compared with a refractive index difference in the sealing member (27).

13. The luminaire (100) according to any one of claims 8 to 12, wherein a center of the columnar section (61) is located on the light-emitting element (21).

14. The luminaire (100) according to any one of claims 8 to 13, wherein centers of the plurality of columnar sections (61) are respectively located on the plurality of light-emitting elements (21).
